# EUROPEAN PATENT SPECIFICATION

(11) **EP 4 068 409 B1**
(45) Date of publication and mention of the grant of the patent: **30.04.2025**
(21) Application number: 22161714.5
(22) Date of filing: 11.03.2022
(51) Int. Cl.: H01L 25/075, H01L 25/16, H10K 71/12, H10K 59/122, H10K 71/00, H10K 50/81

(54) **DISPLAY DEVICE**
ANZEIGEVORRICHTUNG
DISPOSITIF D'AFFICHAGE

(30) Priority: 11.03.2021 KR 20210032301
(43) Date of publication of application: 05.10.2022
(60) Divisional application: 25160065.6
(73) Proprietor: Samsung Display Co., Ltd., Yongin-si, Gyeonggi-do 17113 (KR)
(72) Inventor: KIM, Ji Yoon, Yongin-si, Gyeonggi-do 17113 (KR)
(74) Representative: Marks & Clerk LLP

(56) References cited:
- US-A1- 2018 342 492

## Description

### BACKGROUND

### 1. Technical Field

Various embodiments of the disclosure relate to a display device.

### 2. Description of Related Art

With an increase in interest in an information display and an increase in demand to use portable information media, demand for display devices is markedly increased, and commercialization thereof is in progress.

US 2018/342492 A1 relates to a micro light-emitting-diode display panel and a manufacturing method thereof.

### SUMMARY

Various embodiments of the disclosure are directed to a display device, which is capable of enhancing the yield of a display panel and enhancing the luminance and efficiency of the display panel.

An embodiment of the disclosure provides a display device including a base layer; a pixel circuit layer located over the base layer; the pixel circuit layer including a transistor located over the base layer and a passivation layer covering the transistor, a first electrode located over the passivation layer of the pixel circuit layer; a bank located over the passivation layer of the pixel circuit layer; a light emitting element comprising a coupling electrode layer located over the first electrode; an insulating layer disposed between the light emitting element and the bank and exposing an upper surface of the light emitting element and a second electrode located over the light emitting element. The transistor includes an active layer; a gate electrode; a first electrode; and a second electrode. The first electrode is electrically connected to the second electrode of the transistor through a contact hole of the passivation layer. The insulating layer is located over the passivation layer and the first electrode and the insulating layer overlaps at least a portion of the passivation layer and the first electrode. The first electrode and the bank are spaced apart from each other and the second electrode entirely overlaps the insulating layer and also directly contacts and entirely overlaps in a cross-sectional view the upper surface of the light emitting element

In an embodiment, a distance between an end of the first electrode and an end of the bank may be in a range of 1 *µ*m to 2 *µ*m.

In an embodiment, the light emitting element may include a first semiconductor layer; an active layer located on a first surface of the first semiconductor layer; and a second semiconductor layer located on a first surface of the active layer, and the coupling electrode layer may be located on a second surface of the first semiconductor layer.

In an embodiment, the coupling electrode layer may be electrically connected to the first electrode.

In an embodiment, the second semiconductor layer may be electrically connected to the second electrode.

In an embodiment, a thickness of the first electrode may be in a range of 1100Å to 1300Å.

In an embodiment, the display device may include an emission area, a non-emission area enclosing the emission area, the bank may be located in the non-emission area, and may comprise an opening corresponding to the emission area; the first electrode may be located in the opening of the bank; the light emitting element may be located in the emission area; and the second electrode may entirely overlap the bank and the first electrode.

In an embodiment, a distance between an outside of the first electrode and an inside of the bank may be in a range of 1 *µ*m to 2 *µ*m.

In an embodiment, the first electrode may be an anode electrode, the first electrode may be electrically connected to an electrode of a driving transistor through a contact hole, and the contact hole may be located in the emission area.

In an embodiment, the light emitting element may include a first semiconductor layer; an active layer located on a first surface of the first semiconductor layer; and a second semiconductor layer located on a first surface of the active layer, and the coupling electrode layer may be located on a second surface of the first semiconductor layer.

In an embodiment, the coupling electrode layer may be electrically connected to the first electrode.

In an embodiment, the second semiconductor layer may be electrically connected to the second electrode.

At least some of the above and other features of the invention are set out in the claims.

### BRIEF DESCRIPTION OF THE DRAWINGS

An additional appreciation according to the embodiments of the disclosure will become more apparent by describing in detail the embodiments thereof with reference to the accompanying drawings, wherein:
FIGS. 1 and 2 are schematic perspective views illustrating a light emitting element included in a display device in accordance with an embodiment of the disclosure.
FIG. 3 is a schematic cross-sectional view illustrating a light emitting element included in a display device in accordance with an embodiment of the disclosure.
FIG. 4 is a schematic plan view illustrating a display panel of a display device in accordance with an embodiment of the disclosure.
FIG. 5 is a schematic circuit diagram illustrating a pixel of a display device in accordance with an embodiment of the disclosure.
FIG. 6 is a schematic plan view illustrating a pixel of a display device in accordance with an embodiment of the disclosure.
FIG. 7 is a schematic cross-sectional view taken along line VIII-VIII' of FIG. 6.
FIG. 8 is a schematic cross-sectional view taken along line IX-IX' of FIG. 6.
FIGS. 9 to 11 are schematic cross-sectional views illustrating a method of manufacturing a display device in accordance with an embodiment of the disclosure.
FIG. 12 is a schematic cross-sectional view illustrating a display device in accordance with a comparative example.
FIG. 13 is a schematic cross-sectional view illustrating a display device in accordance with an embodiment of the disclosure.
FIG. 14 is a schematic plan view illustrating a pixel of a display device in accordance with an embodiment of the disclosure.
FIG. 15 is a schematic cross-sectional view taken along line XV-XV' of FIG. 14.
FIG. 16 is a schematic cross-sectional view illustrating a display device disclosed herein but not forming part of the claimed invention.

### DETAILED DESCRIPTION OF THE EMBODIMENTS

As the disclosure allows for various changes and numerous embodiments, particular embodiments will be illustrated in the drawings and described in detail in the written description. However, this is not intended to limit the disclosure to particular modes of practice, and it is to be appreciated that all changes, equivalents, and substitutes that do not depart from the technical scope of the disclosure are encompassed in the disclosure.

It will be understood that, although the terms "first," "second," and the like may be used herein to describe various elements, these elements should not be limited by these terms. These terms are only used to distinguish one element from another element. For instance, a first element discussed below could be termed a second element without departing from the teachings of the disclosure. Similarly, the second element could also be termed the first element. In the disclosure, the singular forms are intended to include the plural meanings as well, unless the context clearly indicates otherwise.

It will be further understood that the terms "comprise," "include," "have," etc., when used in this specification, specify the presence of stated features, integers, steps, operations, elements, components, and/or combinations of them but do not preclude the presence or addition of one or more other features, integers, steps, operations, elements, components, and/or combinations thereof. Furthermore, when a first part such as a layer, a film, an area, or a plate is disposed on a second part, the first part may be not only directly on the second part but a third part may intervene between them. In addition, when it is expressed that a first part such as a layer, a film, an area, or a plate is formed on a second part, the surface of the second part on which the first part is formed is not limited to an upper surface of the second part but may include other surfaces such as a side surface or a lower surface of the second part. To the contrary, when a first part such as a layer, a film, an area, or a plate is under a second part, the first part may be not only directly under the second part but a third part may intervene between them.

It will be understood that the terms "contact," "connected to," and "coupled to" may include a physical and/or electrical contact, connection or coupling.

The phrase "at least one of" is intended to include the meaning of "at least one selected from the group of" for the purpose of its meaning and interpretation. For example, "at least one of A and B" may be understood to mean "A, B, or A and B."

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, a display device in accordance with an embodiment will be described with reference to the attached drawings.

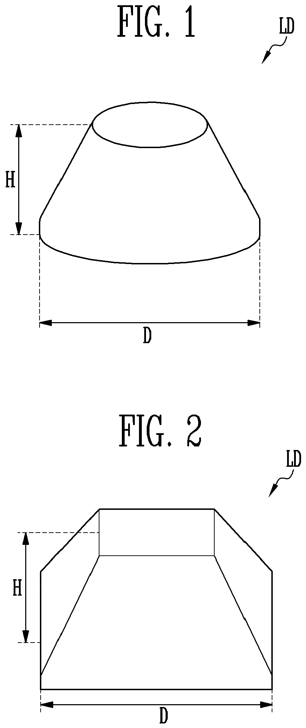

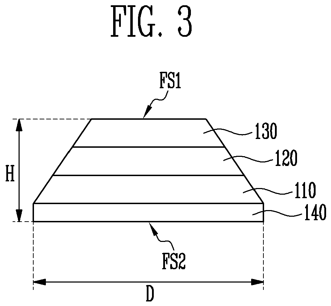

FIGS. 1 and 2 are schematic perspective views illustrating a light emitting element included in a display device in accordance with an embodiment, and FIG. 3 is a schematic sectional view illustrating a light emitting element included in a display device in accordance with an embodiment.

Referring to FIGS. 1 to 3, a light emitting element LD in accordance with an embodiment may include a first semiconductor layer 110, an active layer 120, a second semiconductor layer 130, and a coupling electrode layer 140. For example, the light emitting element LD may be configured as a stacked body formed by successively stacking the coupling electrode layer 140, the first semiconductor layer 110, the active layer 120, and the second semiconductor layer 130 in a direction of a height H.

In the direction of the height H the light emitting element LD, an upper surface of the light emitting element LD may be referred to as a first surface FS1, and a lower surface of the light emitting element LD may be referred to as a second surface FS2.

Each of the first and second surfaces FS1 and FS2 of the light emitting element LD may be formed to have a predetermined shape. For example, as illustrated in FIG. 1, the first surface FS1 and the second surface FS2 of the light emitting element LD may be formed in the shape of a circle or an ellipse. Further, as illustrated in FIG. 2, the first surface FS1 and the second surface FS2 of the light emitting element LD may be formed in the shape of a square or rectangle. The disclosure is not limited thereto, and the first surface FS1 and the second surface FS2 may be formed in a polygonal shape such as a regular triangle, a regular pentagon, or a hexagon.

The light emitting element LD may have a shape, and the area of the first surface FS1 of the light emitting element LD and the area of the second surface FS2 of the light emitting element LD may be different from each other. The cross-sectional area of the light emitting element LD may vary in a direction of a width D. For instance, the area of the first surface FS1 of the light emitting element LD and the area of the second surface FS2 of the light emitting element LD may be different from each other. Thus, as illustrated in FIGS. 1 and 2, in an embodiment, the light emitting element LD may have the shape of a truncated cone or a truncated pyramid whose upper and lower surfaces have different areas. Furthermore, in an embodiment, the light emitting element LD may be formed by stacking the first semiconductor layer 110, the active layer 120, and the second semiconductor layer 130, may have the shape of a truncated cone or a truncated pyramid, and may further include the coupling electrode layer 140 which has the same shape as the first semiconductor layer 110 and is positioned on the lower surface thereof.

The light emitting element LD may have a size corresponding to a range from a nanometer scale to a micrometer scale. The size of the light emitting element LD is not limited thereto. The size of the light emitting element LD may be variously changed depending on design conditions of various devices using the light emitting element LD as a light source, e.g., a display device.

The first semiconductor layer 110 may be a first conductive semiconductor layer. For example, the first semiconductor layer 110 may include at least one p-type semiconductor layer. For instance, the first semiconductor layer 110 may include a p-type semiconductor layer which includes at least one semiconductor material of InAlGaN, GaN, AlGaN, InGaN, AlN, and InN and is doped with a first conductive dopant such as Mg, Zn, Ca, Sr, or Ba. However, the material forming the first semiconductor layer 110 is not limited thereto, and the first semiconductor layer 110 may be formed of (or include) various other materials.

In an embodiment, the first semiconductor layer 110 may include at least one n-type semiconductor. For instance, the first semiconductor layer 110 may include an n-type semiconductor layer which includes at least one semiconductor material of InAlGaN, GaN, AlGaN, InGaN, AlN, and InN and is doped with a second conductive dopant such as Si, Ge, or Sn.

The active layer 120 is disposed on a surface of the first semiconductor layer 110. The active layer 120 is disposed over the first semiconductor layer 110. The active layer 120 may be formed in a single or multiple quantum well structure. In an embodiment, a cladding layer (not shown) doped with a conductive dopant may be formed above and/or under the active layer 120. For example, the cladding layer may be formed of an AlGaN layer or an InAlGaN layer. In an embodiment, a material such as AlGaN or InAlGaN may be used to form the active layer 120, and various other materials may be used to form the active layer 120.

If a voltage equal to or greater than a threshold voltage is applied to the upper and lower surfaces of the light emitting element LD, the light emitting element LD emits light by coupling of electron-hole pairs in the active layer 120. By controlling the light emission of the light emitting element LD using the foregoing principle, it may be used as the light source for various display devices.

The second semiconductor layer 130 is disposed on a surface of the active layer 120. The second semiconductor layer 130 is disposed over the active layer 120. The second semiconductor layer 130 may include a second conductive semiconductor layer of a type different from that of the first semiconductor layer 110. For example, the second semiconductor layer 130 may include at least one n-type semiconductor. For instance, the second semiconductor layer 130 may include an n-type semiconductor layer which includes at least one semiconductor material of InAlGaN, GaN, AlGaN, InGaN, AlN, and InN and is doped with a second conductive dopant such as Si, Ge, or Sn. However, the material forming the second semiconductor layer 130 is not limited thereto, and the second semiconductor layer 130 may be formed of various other materials.

In an embodiment, the second semiconductor layer 130 may include at least one p-type semiconductor layer. For instance, the second semiconductor layer 130 may include a p-type semiconductor layer which includes at least one semiconductor material of InAlGaN, GaN, AlGaN, InGaN, AlN, and InN and is doped with a first conductive dopant such as Mg, Zn, Ca, Sr, or Ba.

An electrode layer (not shown) may be disposed on a surface of the second semiconductor layer 130. The electrode layer may include a metal or metal oxide and may include at least one of Cr, Ti, Al, Au, Ni, ITO, IZO, ITZO, and an oxide or alloy thereof. Furthermore, the electrode layer may be substantially transparent or translucent. Thereby, light generated from the light emitting element LD may be emitted to the outside of the light emitting element LD after passing through the electrode layer. The electrode layer may directly contact a second electrode (e.g., a cathode) of a pixel and will be described below.

The coupling electrode layer 140 is disposed on another surface of the first semiconductor layer 110. The coupling electrode layer 140 may be disposed under the first semiconductor layer 110.

The coupling electrode layer 140 may include metal or metal oxide. For example, the coupling electrode layer 140 may include at least one of metal, fusible alloy, or eutectic alloy which has excellent electrical properties and a melting point of about 300°C or less. For instance, the coupling electrode layer 140 may include at least one of Sn, Bi, In, Ga, Sb, Pb, Cd, and an alloy thereof. The coupling electrode layer 140 may include soldering metal for mounting a semiconductor chip. Further, the coupling electrode layer 140 may include at least one of Cr, Ti, Al, Au, Ni, ITO, IZO, ITZO, and an oxide or alloy thereof. In an embodiment, the coupling electrode layer 140 and the electrode layer may include the same or different materials.

The coupling electrode layer 140 may be substantially transparent or translucent. Thereby, light generated from the light emitting element LD may be emitted to the outside of the light emitting element LD after passing through the coupling electrode layer 140. The coupling electrode layer 140 may directly contact a first electrode (e.g., an anode) of the pixel, described below. In other words, as the coupling electrode layer 140 directly contacts the first electrode of the pixel, driving voltage or current may be stably transmitted to the first semiconductor layer 110 of the light emitting element LD. Accordingly, the coupling electrode layer 140 may increase a coupling force between the light emitting element LD and the first electrode, thereby providing a display device having improved luminance, lifespan, and yield.

The coupling electrode layer 140 and the electrode layer may be an ohmic contact electrode or a Schottky contact electrode, but the disclosure is not limited thereto.

In the above-described embodiment, it has been described that the first semiconductor layer 110 and the second semiconductor layer 130 each are composed of a single layer, but the disclosure is not limited thereto. In an embodiment, depending on the material of the active layer 120, each of the first semiconductor layer 110 and the second semiconductor layer 130 may further include one or more layers, e.g., a cladding layer and/or a tensile strain barrier reducing (TSBR) layer. The TSBR layer may be a strain mitigating layer which is disposed between semiconductor layers having different lattice structures to serve as a buffer for reducing a difference in lattice constant. Although the TSBR layer may be formed of a p-type semiconductor layer such as p-GaInP, p-AlInP, or p-AlGaInP, the disclosure is not limited thereto.

In an embodiment, the light emitting element LD may further include additional components as well as the first semiconductor layer 110, the active layer 120, the second semiconductor layer 130, and/or the coupling electrode layer 140.

Furthermore, in an embodiment, the light emitting element LD may further include on a surface thereof an insulating film. The insulating film may be formed on the surface of the light emitting element LD to enclose an outer circumferential surface of the active layer 120. The insulating film may further enclose an area of each of the first semiconductor layer 120, the second semiconductor layer 130, and the coupling electrode layer 140. However, the insulating film may expose the upper and lower surfaces of the light emitting element LD having different polarities. For example, the insulating film may not cover but expose a first end of each of the first and second semiconductor layers 110 and 130 located at both ends of the light emitting element LD in the direction of the height, for example, two bottom surfaces (the upper and lower surfaces of the light emitting element LD). In the case that the insulating film is provided on the surface of the light emitting element LD, in particular, the surface of the active layer 120, the active layer 120 may be prevented from short-circuiting with at least one electrode or the like. Consequently, the electrical stability of the light emitting element LD may be secured.

Furthermore, by forming the insulating film on the surface of the light emitting element LD, occurrence of a defect on the surface of the light emitting element LD may be reduced or minimized, so that the lifespan and efficiency of the light emitting element may be improved. If the insulating film is formed on each light emitting element LD, even in the case that the light emitting elements LD are disposed adjacent to each other, the undesired short-circuiting between the light emitting elements LD may be prevented.

In an embodiment, a surface treatment process may be performed to fabricate the light emitting element LD. For example, the light emitting element LD may be surface-treated so that, when light emitting elements LD are mixed with a fluidic solution (or solvent) and then supplied to each emission area (e.g., an emission area of each pixel), the light emitting elements LD can be uniformly distributed without non-uniformly aggregating in the solution.

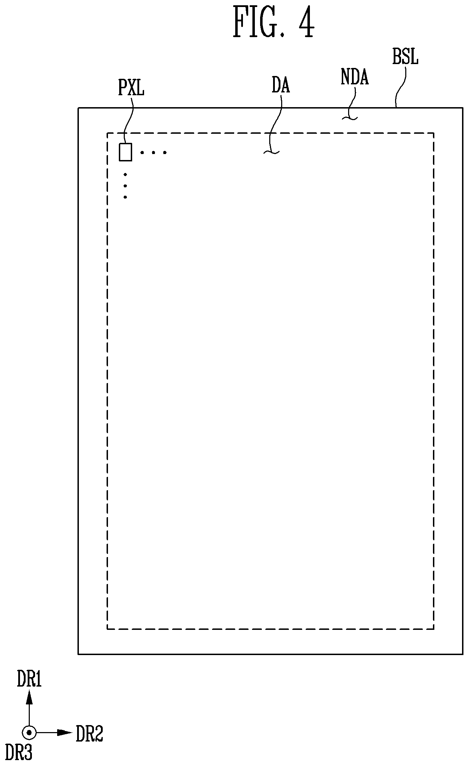

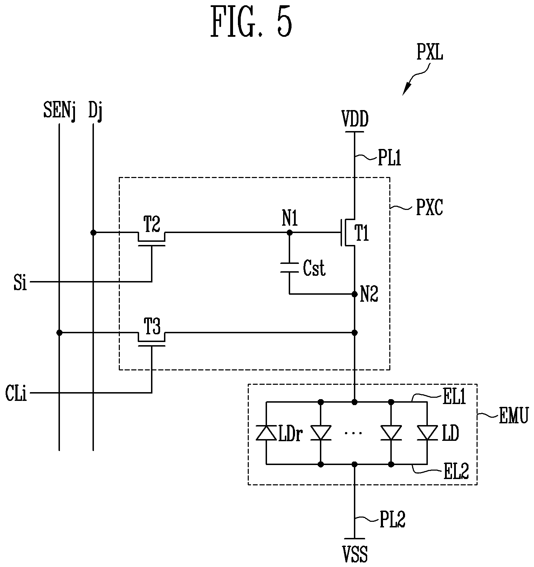

Hereinafter, a display panel of a display device and a pixel included in the display device in accordance with an embodiment will be described with reference to FIGS. 4 and 5.

FIG. 4 is a plan view schematically illustrating a display panel of a display device in accordance with an embodiment, and FIG. 5 is a schematic circuit diagram illustrating a pixel of a display device in accordance with an embodiment.

First, referring to FIG. 4, the display panel of the display device in accordance with an embodiment may include a base layer BSL and pixels PXL disposed on the base layer BSL.

Specifically, the display panel of the display device and the base layer BSL for forming the same include a display area DA displaying an image and a non-display area NDA excluding the display area DA. The non-display area NDA may be a bezel area configured to enclose the display area DA.

The base layer BSL may form (or constitute) a base member of the display panel. In an embodiment, the base layer BSL may be a rigid or flexible substrate or film, and the material or properties thereof are not particularly limited. For example, the base layer BSL may be a rigid substrate made of glass or reinforced glass, a soft substrate (or a thin film) made of plastic or a metal material, or at least one insulating film, and the material and/or properties thereof are not particularly limited.

Furthermore, the base layer BSL may be transparent, but the disclosure is not limited thereto. For instance, the base layer BSL may be a transparent, translucent, opaque, or reflective base member.

The display area DA may be located on a surface of the display panel. For example, the display area DA may be located on a front surface of the display panel and may be additionally located on side and rear surfaces of the display panel.

The non-display area NDA is located around the display area DA to enclose the display area DA. The non-display area NDA may selectively include lines, pads, and a driving circuit electrically connected to the pixels PXL of the display area DA.

Although only a pixel PXL is shown in FIG. 4, the pixels PXL may be substantially distributed and disposed in the display area DA. In an embodiment, the pixels PXL may be arranged in a matrix, stripe, or PenTile^{®} arrangement structure in the display area DA. However, the disclosure is not limited thereto.

FIG. 5 illustrates a pixel PXL included in an i-th pixel row and a j-th pixel column (where i and j are positive integers).

Referring to FIG. 5, the pixel PXL may include a driving circuit PXC and an emission unit (or light emission unit or emission part) EMU.

The driving circuit PXC may include a first transistor T1, a second transistor T2, a third transistor T3, and a storage capacitor Cst.

A first electrode of the first transistor T1 (or a driving transistor) may be electrically connected to a first power supply line PL1, and a second electrode thereof may be electrically connected to a first electrode EL1 (or a second node N2) of the emission unit EMU. A gate electrode of the first transistor T1 may be electrically connected to a first node N1. In an embodiment, the first electrode may be a drain electrode, and the second electrode may be a source electrode.

The first transistor T1 may control the amount of driving current flowing to the emitting unit EMU in response to a voltage of the first node N1. In an embodiment, the first transistor T1 may selectively include a bottom metal layer (not shown). The gate electrode and the bottom metal layer of the first transistor T1 may overlap each other with an insulating layer interposed therebetween. In an embodiment, by electrically connecting the bottom metal layer to the second electrode of the first transistor T1 and then applying source-sink technology, a threshold voltage of the first transistor T1 may be moved in a negative or positive direction.

A first electrode of the second transistor T2 (or switching transistor) may be electrically connected to a data line Dj, and a second electrode thereof may be electrically connected to the first node N1 (or the gate electrode of the first transistor T1). A gate electrode of the second transistor T2 may be electrically connected to a first scan line Si. In the case that a first scan signal (e.g., a high-level voltage) is supplied to the first scan line Si, the second transistor T2 may be turned on to transmit a data voltage from the data line Dj to the first node N1.

A first electrode of the third transistor T3 may be electrically connected to a sensing line SENj, while a second electrode thereof may be electrically connected to the second node N2 (or the second electrode of the first transistor T1). A gate electrode of the third transistor T3 may be electrically connected to a second scan line CLi. In the case that the second scan signal (e.g., a high-level voltage) is supplied to the second scan line CLi during a sensing period, the third transistor T3 may be turned on to electrically connect the sensing line SENj and the second node N2.

The storage capacitor Cst may be electrically connected between the first node N1 and the second node N2. The storage capacitor Cst may charge a data voltage corresponding to a data signal supplied to the first node N1 during a frame. Thus, the storage capacitor Cst may store a voltage corresponding to a difference in voltage between the first node N1 and the second node N2. For example, the storage capacitor Cst may store a voltage corresponding to a difference between a data voltage supplied to the gate electrode of the first transistor T1 and an initialization voltage supplied to the second electrode of the first transistor T1.

The emission unit EMU may include light emitting elements LD electrically connected in parallel between a first power supply line PL1 to which a first driving voltage VDD is applied and a second power supply line PL2 to which a second driving voltage VSS is applied.

To be more specific, the emission unit EMU may include light emitting elements LD electrically connected in parallel between the first electrode EL1 electrically connected to the second node N2 and a second electrode EL2 electrically connected to the second power supply line PL2. Here, the first electrode EL1 may be an anode electrode, and the second electrode EL2 may be a cathode electrode.

The first and second driving voltages VDD and VSS may be different voltages to allow the light emitting elements LD to emit light. For example, the first driving voltage VDD may be set as a high-potential voltage, and the second driving voltage VSS may be set as a low-potential voltage. Here, a difference in voltage between the first and second driving voltages VDD and VSS may be set to a value which is equal to or greater than a threshold voltage of the light emitting elements LD during an emission period of the pixel PXL. Thus, the emission unit EMU may generate light having a predetermined luminance corresponding to driving current supplied from the first transistor T1. For example, during a frame period, the first transistor T1 may supply driving current corresponding to a grayscale value of corresponding frame data to the emission unit EMU. The driving current supplied to the emission unit EMU may be divided and flow into the light emitting elements LD. Hence, each of the light emitting elements LD may emit light having a luminance corresponding to current applied thereto, so that the emission unit EMU may emit light having a luminance corresponding to the driving current.

The emission unit EMU may include at least one light emitting element LD aligned in a first direction and at least one light emitting element LDr aligned in a second direction opposite to the first direction.

In an embodiment, the light emitting elements LD electrically connected in parallel between the first power supply line PL1 and the second power supply line PL2 may be electrically connected through n serial stages. A serial stage may include the light emitting elements LD electrically connected in parallel in the same direction.

The circuit structure of the pixel PXL according to the disclosure is not limited to that illustrated in FIG. 5. For example, the emission unit EMU may be located between the first power supply line PL1 and the first electrode of the first transistor T1.

In FIG. 5, the transistor is illustrated as an NMOS transistor. However, the disclosure is not limited thereto. For example, at least one of the first to third transistors T1, T2, and T3 may be implemented as a PMOS. Further, the first to third transistors T1, T2, and T3 shown in FIG. 5 may be thin film transistors each including at least one of an oxide semiconductor, an amorphous silicon semiconductor, and a polycrystalline silicon semiconductor.

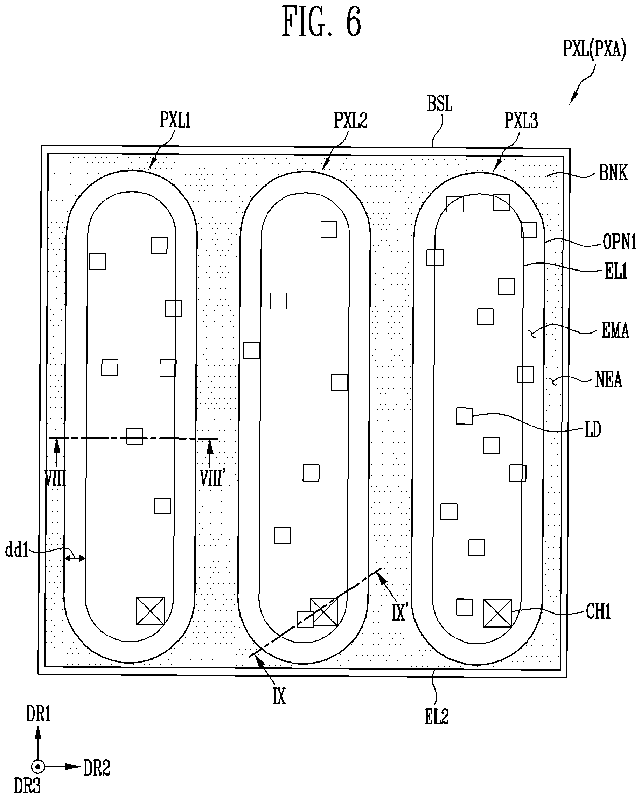

Hereinafter, the configuration of a display device in accordance with an embodiment will be described with reference to FIGS. 6 to 8.

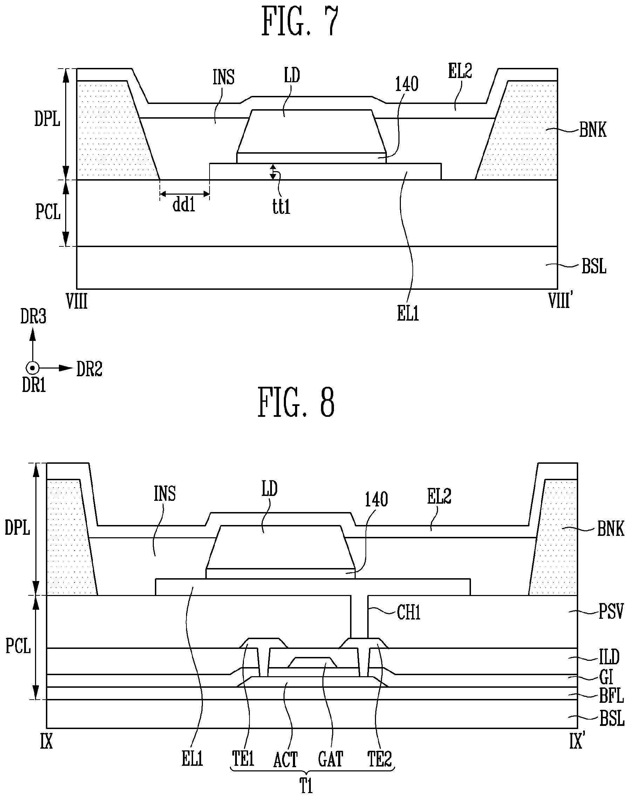

FIG. 6 is a schematic plan view illustrating a pixel of a display device in accordance with an embodiment, FIG. 7 is a schematic sectional view taken along line VIII-VIII' of FIG. 6, and FIG. 8 is a schematic sectional view taken along line IX-IX' of FIG. 6.

For the convenience of description, some of the transistors electrically connected to the light emitting elements LD and the signal lines electrically connected to the transistors are omitted from FIG. 6.

Referring to FIG. 6, a pixel PXL may be disposed in a pixel area PXA which is provided in the display area DA (see FIG. 4) of the base layer BSL. The pixel area PXA of the base layer BSL may include an emission area EMA and a non-emission area NEA excluding the emission area EMA. The non-emission area NEA may enclose the emission area EMA.

The pixel PXL may include a first pixel PXL1, a second pixel PXL2, and a third pixel PXL3. The first pixel PXL1, the second pixel PXL2, and the third pixel PXL3 each may display a color of blue, red, and green. Since the first pixel PXL1, the second pixel PXL2, and the third pixel PXL3 include the same components, the components included in the first pixel PXL1 will be mainly described below.

The first pixel PXL1 may include a bank BNK, a first electrode EL1, a second electrode EL2, and light emitting elements LD.

The bank BNK is located in the non-emission area NEA of the pixel area PXA. The bank BNK may be a structure which defines (or partitions) the emission area EMA and/or the pixel area PXA of each of the pixels PXL with respect to the first pixel PXL1 and the third pixel PXL3 adjacent to the illustrated second pixel PXL2. In a process of supplying the light emitting elements LD to the first, second, and third pixels PXL1, PXL2, and PXL3, the bank BNK may be a pixel defining layer or a dam structure defining an area to which the light emitting elements LD are to be supplied. For example, the emission areas EMA of the first, second, and third pixels PXL1, PXL2, and PXL3 are partitioned by the bank BNK, so that a mixed solution (e.g., ink) containing a desired amount and/or type of light emitting elements LD may be supplied (or injected) to the emission area EMA.

The bank BNK may include at least one opening which exposes components located under the bank BNK in the pixel area PXA. For example, the bank BNK may include a first opening OPN1 which exposes the components located under the bank BNK. The first opening OPN1 may correspond to the emission area EMA of the pixel PXL. In other words, the first electrode EL1, the light emitting elements LD, and a first contact hole CH1 may be located in the first opening OPN1. In an embodiment, an edge of the first opening OPN1 may be referred to as the inside of the bank BNK.

The first electrode EL1 may be located in the emission area EMA. In other words, the first electrode EL1 may be located in the first opening OPN1 of the bank BNK. The first electrode EL1 is spaced apart from the bank BNK. For example, a first distance dd1 between the outside of the first electrode EL1 and the inside of the bank BNK may be about 1 µm to about 2 µm.

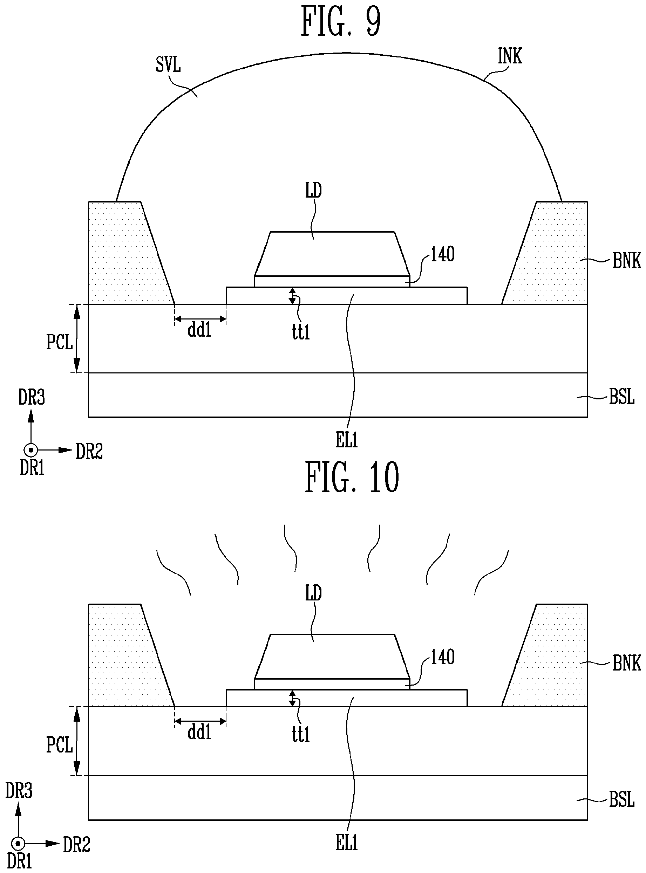

In an embodiment, the first electrode EL1 is spaced apart from the bank BNK in the first opening OPN1 of the bank BNK. Thus, even if the light emitting element LD is disposed at an angle with respect to the bank BNK in a process of disposing the light emitting element LD, it is possible to prevent the short-circuit of the display device from occurring. The short-circuit phenomenon of the display device and the features of the disclosure for preventing such a short-circuit phenomenon will be described in detail with reference to FIGS. 9 to 13.

The first electrode EL1 may be an anode electrode of the emitting unit EMU described with reference to FIG. 5. Thus, the first electrode EL1 may be physically and/or electrically connected to the second electrode of the first transistor T1 (see FIG. 5) through the first contact hole CH1 located in the emission area EMA.

The first contact hole CH1 may be located to overlap the light emitting element LD. In other words, the light emitting element LD may be located to overlap the first electrode EL1 electrically connected to the first contact hole CH1, and be located to overlap at least partially the first transistor T1 electrically connected to the first contact hole CH1.

In an embodiment, as the first contact hole CH1 electrically connecting the first electrode EL1 and the first transistor T1 is located in the emission area EMA, the non-emission area NEA (or the non-display area NDA (see FIG. 4)) may be reduced and the emission area EMA may be increased. Thus, an opening ratio can be secured and the luminance and efficiency of the display panel can be increased.

The second electrode EL2 is positioned throughout the pixel area PXA. The second electrode EL2 may entirely overlap the bank BNK and the first electrode EL1.

The second electrode EL2 may be a cathode electrode of the emission unit EMU described with reference to FIG. 5. Thus, the second electrode EL2 may be physically and/or electrically connected to the second driving voltage VSS (or the second power supply line PL2) through a contact hole (not shown).

The light emitting elements LD may be located in the emission area EMA. In other words, the light emitting elements LD may be arbitrarily disposed in the first opening OPN1 of the bank BNK.

In an embodiment, as the first contact hole CH1 electrically connecting the first electrode EL1 and the first transistor T1 is located in the emission area EMA to enlarge the light emitting area EMA, a large number of light emitting elements LD may be disposed in the emission area EMA. Thus, the luminance of the display panel can be increased.

Even if the first contact hole CH1 is located in the emission area EMA, an insulating layer INS (see FIGS. 7 and 8) covering (or overlapping) the first electrode EL1 is formed, so that it may not affect the performance of the light emitting element LD.

Referring to FIGS. 7 and 8, the display device in accordance with an embodiment may include a base layer BSL, a pixel circuit layer PCL, and a display element layer DPL.

The base layer BSL may be a rigid substrate or a flexible substrate. For example, the rigid substrate may be made of glass, or quartz, etc., and the flexible substrate may be made of at least one of polyimide, polycarbonate, polystyrene, and polyvinyl alcohol. However, an embodiment is not limited thereto.

The pixel circuit layer PCL is located over the base layer BSL. The pixel circuit layer PCL may include a buffer layer BFL, a first transistor T1, a gate insulating layer GI, an interlayer insulating layer ILD, and a passivation layer PSV

The buffer layer BFL is located over the base layer BSL. The buffer layer BFL may prevent impurities from being diffused from an external source into the pixel circuit layer PCL. The buffer layer BFL may include at least one of metal oxides such as silicon nitride (SiNₓ), silicon oxide (SiOₓ), silicon oxynitride (SiOₓN_{y}), and aluminium oxide (AlOₓ). In some embodiments, the buffer layer BFL may be omitted.

The first transistor T1 includes an active layer ACT, a gate electrode GAT, a first electrode TE1, and a second electrode TE2. Here, the first transistor T1 may correspond to the first transistor T1 of FIG. 5, which has been described above.

The active layer ACT is located over the buffer layer BFL. The active layer ACT may include at least one of polysilicon, amorphous silicon, and oxide semiconductor.

The active layer ACT may include a source area electrically connected to the second electrode TE2 of the first transistor T1, a drain area electrically connected to the first electrode TE1, and a channel area between the source area and the drain area.

The gate insulating layer GI is located over the active layer ACT and the buffer layer BFL to cover the active layer ACT and the buffer layer BFL. The gate insulating layer GI may include an inorganic material. For example, the gate insulating layer GI may include at least one of silicon nitride (SiNₓ), silicon oxide (SiOₓ), silicon oxynitride (SiOₓN_{y}), and aluminium oxide (AlOₓ). In an embodiment, the gate insulating layer GI may include an organic material.

The gate electrode GAT is located over the gate insulating layer GI. The gate electrode GAT may be located to overlap the channel area of the active layer ACT.

The interlayer insulating layer ILD is located over the gate electrode GAT and is located to cover (or overlapping) the gate electrode GAT and the gate insulating layer GI. The interlayer insulating layer ILD and the gate insulating layer GI may include the same material, and the interlayer insulating layer ILD may include at least one of silicon nitride (SiNₓ), silicon oxide (SiOₓ), silicon oxynitride (SiOₓN_{y}), and aluminium oxide (AlOₓ).

The first electrode TE1 and the second electrode TE2 of the first transistor T1 are located over the interlayer insulating layer ILD. The first electrode TE1 may pass through the gate insulating layer GI and the interlayer insulating layer ILD to contact the drain area of the active layer ACT, while the second electrode TE2 may pass through the gate insulating layer GI and the interlayer insulating layer ILD to contact the source area of the active layer ACT.

The passivation layer PSV is located over the first electrode TE1 and the second electrode TE2 of the first transistor T1 and is located to cover (or overlap) the first electrode TE1 and the second electrode TE2 of the first transistor T1 and the interlayer insulating layer ILD. The passivation layer PSV may include an inorganic material or organic material.

The second electrode TE2 of the first transistor T1 and the first electrode EL1 of the display element layer DPL are electrically connected to each other through the first contact hole CH1 of the passivation layer PSV.

The display element layer DPL is located over the pixel circuit layer PCL. The display element layer DPL may include a first electrode EL1, a bank BNK, a light emitting element LD, an insulating layer INS, and a second electrode EL2.

The first electrode EL1 is located over the passivation layer PSV of the pixel circuit layer PCL. The first electrode EL1 may be located over the passivation layer PSV to be spaced apart from the bank BNK, which will be described below. The first electrode EL1 is electrically connected through the first contact hole CH1 of the passivation layer PSV to the second electrode TE2 of the first transistor T1. Thus, the first driving voltage VDD of FIG. 5 may be applied to the first electrode EL1.

The first electrode EL1 may include a transparent conductive material. For example, the first electrode EL1 may include Cu, Au, Ag, Mg, Al, Pt, Pb, Ni, Nd, Ir, Cr, Li, Ca, a mixture thereof, ITO, IZO, ZnO, ITZO, etc. However, the disclosure is not limited thereto.

The thickness tt1 of the first electrode EL1 may correspond to about 1,100 Å to about 1,300 Å. To be more specific, the thickness tt1 of the first electrode EL1 may be about 1,200 Å. For example, in the case that the first electrode EL1 is implemented as a triple layer including a lower layer, an intermediate layer, and an upper layer, the lower layer including ITO may be implemented to have a thickness of about 50 Å, the intermediate layer including Ag may be implemented to have a thickness of about 1,000 Å, and the upper layer including ITO may be implemented to have a thickness of about 70 Å. The disclosure is not limited thereto. In an embodiment, the material and/or thickness of the lower layer, the intermediate layer, and the upper layer may vary.

In the process of arranging the light emitting elements LD, even if at least one light emitting element LD is obliquely positioned on one end (or first end) of the first electrode EL1 to at least partially overlap the first end, the coupling electrode layer 140 of the light emitting element LD may contact only the first electrode EL1 and may not contact the second electrode EL2. In other words, the coupling electrode layer 140 of the light emitting element LD may not contact the first electrode EL1 and the second electrode EL2 at the same time. Therefore, in the case that the light emitting element LD is electrically connected, it is possible to reduce the risk of a short circuit. Furthermore, the light emitting element LD is obliquely positioned on the first end of the first electrode EL1 to at least partially overlap the first end. Thus, even if the light emitting element LD does not emit light, it is possible to reduce the failure of the display device because the light emitting element LD does not cause a failure.

The bank BNK is located over the passivation layer PSV of the pixel circuit layer PCL. The bank BNK may be a structure capable of partitioning each pixel area. The first electrode EL1, the light emitting element LD, and the like may be positioned between two adjacent banks BNK. The bank BNK may contain an organic material.

The bank BNK may have a trapezoidal or rectangular shape having a cross-section whose width of the upper side (or top side) is shorter than a width of the lower side (or bottom surface). However, the disclosure is not limited thereto. In an embodiment, the bank BNK may have a curved shape having a cross-section such as a semi-elliptical shape, a semicircular shape, and the like.

A first end of the bank BNK and the first end of the first electrode EL1 may be spaced apart from each other. The first end of the first electrode EL1 and the first end of the adjacent bank BNK may be spaced apart from each other by a first distance dd1. For example, the first distance dd1 may correspond to about 1 µm to about 2 µm. In other words, a distance margin between the bank BNK and the first electrode EL1 may be secured. Therefore, in the process of arranging the light emitting elements LD, even if at least one light emitting element LD is obliquely positioned along a side surface of the bank BNK, the light emitting element LD electrically connecting the first electrode EL1 and the second electrode EL2 may be spaced apart from the first electrode EL1. Thus, in case that the display device is electrically connected, the possibility of a short circuit may be reduced.

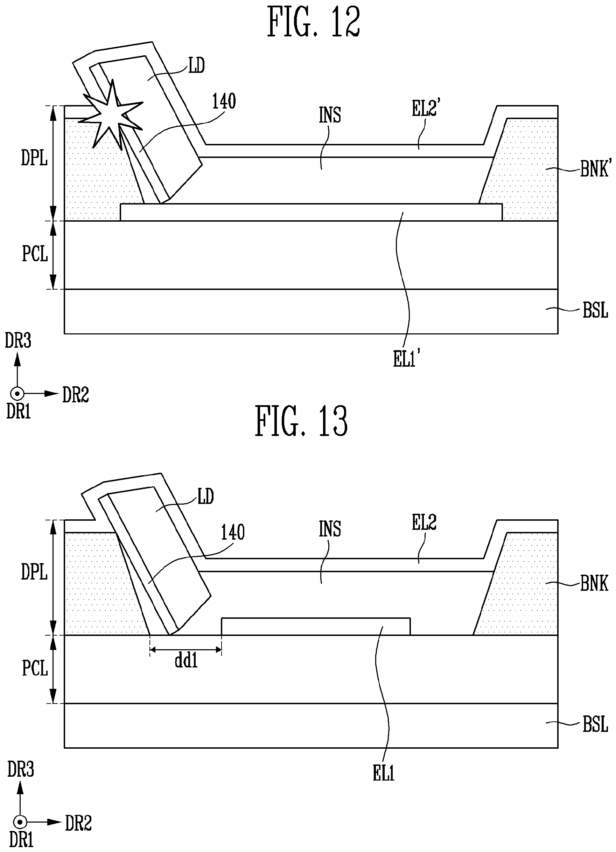

The light emitting element LD is located over the first electrode EL1. Specifically, in an embodiment, the coupling electrode layer 140 of the light emitting element LD may be located over the first electrode EL1, and the first electrode EL1 and the coupling electrode layer 140 of the light emitting element LD may directly contact each other. Thus, the first driving voltage VDD of FIG. 5 applied to the first electrode EL1 may be transmitted to the light emitting element LD. As the first electrode EL1 directly contacts the coupling electrode layer 140 of the light emitting element LD, the driving voltage or current may be stably transmitted to the first semiconductor layer 110 (see FIG. 3) of the light emitting element LD. Further, the second semiconductor layer 130 (see FIG. 3) of the light emitting element LD may directly contact the second electrode EL2 which will be described below, so that the light emitting element LD may emit light. In contrast, unlike those shown in FIGS. 7 and 8, in the case that the light emitting element LD is vertically disposed over the first electrode EL1, the first electrode EL1 and the second electrode EL2 may be short-circuited by the light emitting element LD. The occurrence of the short-circuit in the display device depending on the arrangement of the light emitting element LD will be described below with reference to FIGS. 12 and 13.

The insulating layer INS is located over the passivation layer PSV and the first electrode EL1 and is located to cover (or overlap) at least a portion of the passivation layer PSV and the first electrode EL1. Further, the insulating layer INS may be positioned between the light emitting element LD and the bank BNK so as to support the light emitting element LD between two adjacent banks BNK. The insulating layer INS may be positioned to cover at least a portion of the side surface of the bank BNK and at least a portion of the side surface of the light emitting element LD. The upper surface of the light emitting element LD may be exposed by the insulating layer INS.

The insulating layer INS may be an organic layer including an organic material. For example, the insulating layer INS may include at least one of polyacrylate resin, epoxy resin, phenolic resin, polyamides resin, polyimides rein, unsaturated polyesters resin, polyphenylen ethers resin, poly-phenylene sulfides resin, and benzocyclobutene resin. The insulating layer INS may be formed as a planarization layer that planarizes the display element layer DPL so as to form the second electrode EL2. In an embodiment, the insulating layer INS may include an inorganic material.

The second electrode EL2 is positioned over the insulating layer INS and the light emitting element LD. The second electrode EL2 is positioned to cover the entire surface of the insulating layer INS and also directly contacts and entirely overlaps in a cross-sectional view the light emitting element LD. The second electrode EL2 may be a cathode. The second electrode EL2 is positioned over the upper surface of the light emitting element LD, and the second electrode EL2 directly contacts the second semiconductor layer 130 (see FIG. 3) of the light emitting element LD. Thus, the second driving voltage VSS of FIG. 5 applied to the second electrode EL2 is transmitted to the light emitting element LD.

In an embodiment, a protective layer (not shown) may be provided over the second electrode EL2. The protective layer and the insulating layer INS may contain the same material, but the disclosure is not limited thereto. The protective layer may be provided over the second electrode EL2 to protect the second electrode EL2 from external oxygen or moisture. Furthermore, in an embodiment, at least one overcoat layer (e.g., a layer that planarizes an upper surface of the display element layer DPL) may be provided over the second electrode EL2.

In an embodiment, the display element layer DPL may selectively further include an optical layer (not shown) as well as the protective layer. For example, the display element layer DPL may further include a color conversion layer (not shown) including color conversion particles that convert light emitted from the light emitting element LD into light of a specific color.

Hereinafter, a method of manufacturing a display device will be described with reference to FIGS. 9 to 11.

FIGS. 9 to 11 are schematic sectional views illustrating a method of manufacturing a display device in accordance with an embodiment, and the display device manufactured by the method of FIGS. 9 to 11 may be the display device illustrated in FIG. 7.

Referring to FIG. 9, a pixel circuit layer PCL, a first electrode EL1, and a bank BNK may be formed over the base layer BSL, and ink INK may be sprayed onto the first electrode EL1.

The ink INK may contain a solvent SVL and a solid content, and the solid content may include light emitting elements LD. The solvent SVL may be composed of acetone, water, alcohol, PMEA, toluene, and the like, and may be a material that is vaporized or volatilized by room temperature or heat.

In an embodiment, since the light emitting element LD corresponds to a structure (e.g., the shape of a truncated cone or a truncated pyramid) in which a width of the lower surface or the upper surface thereof is greater than the length of the light emitting element LD, the upper surface or the lower surface having a relatively large area may be located towards the first electrode EL1. For example, in the case that the light emitting element LD has the shape of the truncated cone or the truncated pyramid, the coupling electrode layer 140 having a relatively larger area may be located towards the first electrode EL1. Therefore, the light emitting element LD and the first electrode EL1 may be physically and/or electrically connected to each other.

Referring to FIG. 10, after the light emitting element LD is disposed, the solvent SVL may be volatilized. The coupling electrode layer 140 of the light emitting element LD may closely contact the first electrode EL1 electrically connected to the pixel circuit layer PCL, and thereby the light emitting element LD may be stably arranged over the pixel circuit layer PCL. The solvent SVL may be vaporized or volatilized by room temperature or heat. As a process temperature increases, a coupling force between the light emitting element LD and the first electrode EL1 may be improved.

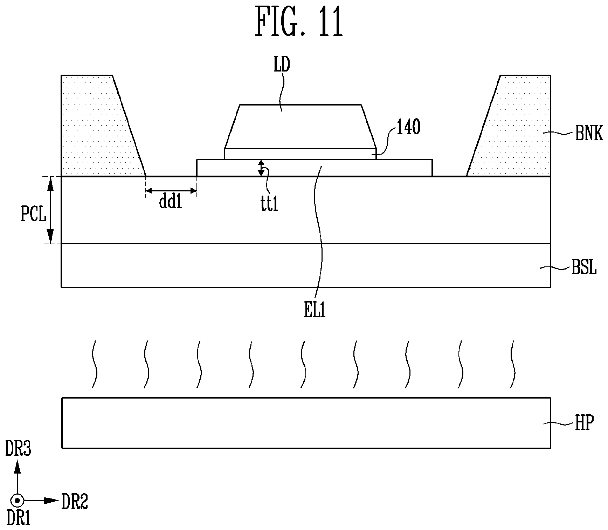

Referring to FIG. 11, the coupling force between the light emitting element LD and the first electrode EL1 may be improved by using a heater HP. For instance, the heater HP may be a hot plate.

As the heater HP is placed under the base layer BSL to apply heat, the coupling force between the first electrode EL1 and the coupling electrode layer 140 of the light emitting element LD may be improved. For example, the temperature may be increased to a degree that the coupling electrode layer 140 of the light emitting element LD may gelate.

However, the disclosure is not limited thereto. In an embodiment, the coupling force between the light emitting element LD and the first electrode EL1 may be improved by using a laser. In the case that the laser is placed between the light emitting element LD and the first electrode EL1, and a laser beam having a wavelength sufficient to melt the coupling electrode layer 140 is radiated onto an interface where the coupling electrode layer 140 and the first electrode EL1 are bonded, the coupling force between the first electrode EL1 and the coupling electrode layer 140 of the light emitting element LD may be improved.

Turning back to FIG. 7, the insulating layer INS is formed over the first electrode EL1. The insulating layer INS may contain an organic material and may be deposited on the first electrode EL1 and the pixel circuit layer PCL by an inkjet printing process or a slit coating process. Subsequently, after the upper surface of the light emitting element LD is exposed by a dry etching process, the second electrode EL2 may be formed throughout the pixel area.

Hereinafter, a difference between a display device according to a comparative example and a display device according to an embodiment will be described with reference to FIGS. 12 and 13.

FIG. 12 is a schematic sectional view illustrating a display device in accordance with a comparative example, and FIG. 13 is a schematic sectional view illustrating a display device in accordance with an embodiment.

First, referring to FIG. 12, the display device in accordance with the comparative example may include a base layer BSL, a pixel circuit layer PCL, and a display element layer DPL. The base layer BSL and the pixel circuit layer PCL may be substantially identical or similar to the base layer BSL and the pixel circuit layer PCL of FIGS. 7 and 8.

The display element layer DPL may include a first electrode EL1', a bank BNK', an insulating layer INS, and a second electrode EL2'.

The first electrode EL1' is located over the pixel circuit layer PCL. The first electrode EL1' may be an anode electrode. The first electrode EL1' may be physically and/or electrically connected to the second electrode of the first transistor included in the pixel circuit layer PCL. Thus, the first driving voltage VDD of FIG. 5 may be applied to the first electrode EL1'.

The bank BNK' is positioned over at least a portion of the pixel circuit layer PCL and the first electrode EL1'. The bank BNK' may be a structure capable of partitioning each pixel area. The first electrode EL1', the light emitting element LD, and the like may be positioned between two adjacent banks BNK'. The bank BNK' may contain an organic material.

A first end of the bank BNK' and a first end of the first electrode EL1' may overlap each other.

The light emitting element LD may be located over the first electrode EL1'. In the arrangement process, the light emitting element LD may be included in ink and sprayed onto the first electrode EL1'. Thus, for example, the coupling electrode layer 140 of the light emitting element LD may be disposed at a predetermined angle with respect to the upper surface of the first electrode EL1' along an oblique side of the bank BNK'.

The insulating layer INS may be positioned between the light emitting element LD and the bank BNK' so as to support the light emitting element LD between two adjacent banks BNK'.

The second electrode EL2' may be positioned over the insulating layer INS and the light emitting element LD. The second electrode EL2' may be a cathode. The second driving voltage VSS of FIG. 5 may be applied to the second electrode EL2', and the second electrode EL2' contacting the light emitting element LD may transmit the second driving voltage VSS of FIG. 5 to the light emitting element LD.

In the comparative example, as the light emitting element LD is obliquely disposed at a predetermined angle with respect to the upper surface of the first electrode EL1', the coupling electrode layer 140 may contact the first electrode EL1' and the second electrode EL2'. Hence, current generated by the first driving voltage VDD and the second driving voltage VSS may be applied to the coupling electrode layer 140, so that a short circuit may occur in the pixel PXL including the light emitting element LD.

On the other hand, referring to FIG. 13, a display device in accordance with an embodiment may include a base layer BSL, a pixel circuit layer PCL, and a display element layer DPL, and the display element layer DPL may include a first electrode EL1, a bank BNK, an insulating layer INS, and a second electrode EL2. The base layer BSL, the pixel circuit layer PCL, and the display element layer DPL may be substantially identical or similar to the base layer BSL, the pixel circuit layer PCL, and the display element layer DPL of FIGS. 7 and 8.

A first end of the bank BNK and a first end of the first electrode EL1 may be spaced apart from each other. The first end of the first electrode EL1 and the first end of the adjacent bank BNK may be spaced apart from each other by a first distance dd1.

In the arrangement process, the light emitting element LD may be included in ink and sprayed onto the first electrode EL1. Thus, for example, the coupling electrode layer 140 of the light emitting element LD may be disposed at a predetermined angle with respect to the upper surface of the pixel circuit layer PCL along the oblique side of the bank BNK.

In an embodiment, since the first end of the first electrode EL1 and the first end of the bank BNK are spaced apart from each other, the light emitting element LD may be spaced apart from the first electrode EL1 even if the light emitting element LD is disposed to be inclined at a predetermined angle. In other words, the light emitting element LD may be located not to contact the first electrode EL1. The light emitting element LD may be located to contact only the second electrode EL2.

Therefore, even if the coupling electrode layer 140 of the light emitting element LD is obliquely disposed on the side surface of the bank BNK at a predetermined angle, the coupling electrode layer 140 contacts the first electrode EL1 or the second electrode EL2, so that it is possible to reduce the short-circuit of the pixel PXL including the light emitting element LD in case that the display device is electrically connected. Therefore, the display device in accordance with an embodiment can enhance the yield of the display panel and can enhance the luminance and efficiency of the display panel.

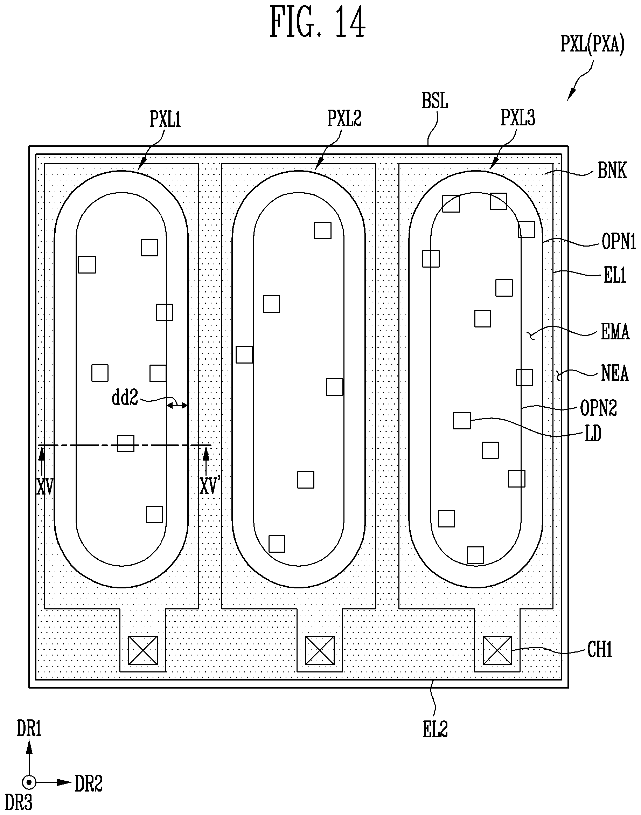

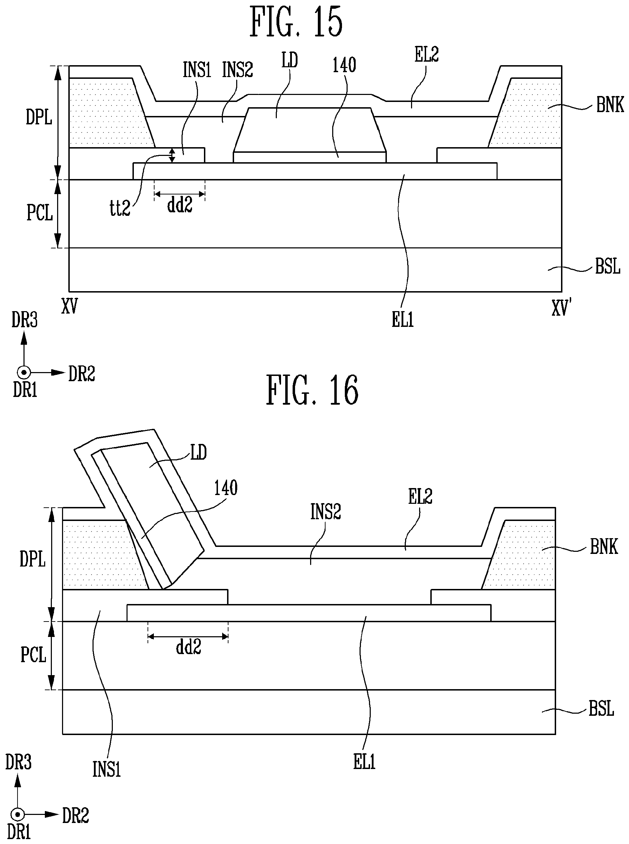

Hereinafter, a display device in accordance with the claimed invention as shown in FIGS. 14 and 15 will be described.

FIG. 14 is a schematic plan view illustrating a pixel of a display device also disclosed herein and not forming part of the claimed invention, and FIG. 15 is a schematic sectional view taken along line XV-XV' of FIG. 14.

First, referring to FIG. 14, a pixel PXL may be disposed in a pixel area PXA which is provided in the display area DA (see FIG. 4) of the base layer BSL. Since the configuration shown in FIG. 14 is similar to that of FIG. 6 described above, differences will be mainly described below.

The first pixel PXL1 may include a bank BNK, a first electrode EL1, a second electrode EL2, and light emitting elements LD.

The bank BNK may include at least one opening which exposes components located under the bank BNK in the pixel area PXA. For example, the bank BNK may include a first opening OPN1 which exposes the components located under the bank BNK. The first opening OPN1 may correspond to the emission area EMA of the pixel PXL. In other words, the first electrode EL1, and the light emitting elements LD may be located in the first opening OPN1. An edge of the first opening OPN1 may be referred to as the inside of the bank BNK.

The first electrode EL1 may at least partially overlap the bank BNK. In other words, the first electrode EL1 may be located to at least partially overlap the first opening OPN1 of the bank BNK.

The first electrode EL1 may be an anode electrode. Thus, the first electrode EL1 may be physically and/or electrically connected to the second electrode of the first transistor T1 of FIG. 5 through the first contact hole CH1 located in the emission area EMA. The first contact hole CH1 may be located in the non-emission area NEA.

The second electrode EL2 is positioned throughout the pixel area PXA. The second electrode EL2 entirely overlaps the bank BNK and the first electrode EL1.

The second electrode EL2 may be a cathode electrode. Thus, the second electrode EL2 may be physically and/or electrically connected to the second driving voltage VSS (or the second power supply line PL2) through the contact hole (not shown).

The light emitting elements LD may be located in the emission area EMA. In other words, the light emitting elements LD may be arbitrarily disposed in the first opening OPN1 of the bank BNK. The first pixel PLX1 may include a second opening OPN2, which is located in the first opening OPN1 in a plan view.

Referring to FIG. 15, a display device also disclosed herein and not forming part of the claimed invention may include a base layer BSL, a pixel circuit layer PCL, and a display element layer DPL. Since the configuration shown in FIG. 15 is similar to that of FIGS. 7 and 8 described above, differences will be mainly described below.

The pixel circuit layer PCL is located over the base layer BSL.

The display element layer DPL is located over the pixel circuit layer PCL. The display element layer DPL may include a first electrode EL1, a bank BNK, a light emitting element LD, first and second insulating layers INS1 and INS2, and a second electrode EL2.

The first electrode EL1 is located over the pixel circuit layer PCL. The first electrode EL1 is physically and/or electrically connected through the first contact hole CH1 of the passivation layer PSV to the second electrode of the first transistor T1 of FIG. 5. Thus, the first driving voltage VDD of FIG. 5 may be applied to the first electrode EL1.

The first insulating layer INS1 is positioned over the pixel circuit layer PCL and the first electrode EL1 to cover at least a portion of the first electrode EL1 and the pixel circuit layer PCL. The thickness tt2 of the first insulating layer INS1 disposed over the first electrode EL1 may range from about 100 Å to about 500 Å.

The first insulating layer INS1 may include an inorganic material. For example, this may include at least one of silicon nitride (SiNₓ), silicon oxide (SiOₓ), silicon oxynitride (SiOₓN_{y}), and aluminium oxide (AlOₓ). The first insulating layer INS1 may include an organic material.

The bank BNK is located over the first insulating layer INS1. The bank BNK may be a structure capable of partitioning each pixel area. The first electrode EL1, the light emitting element LD, and the like may be positioned between two adjacent banks BNK. The bank BNK may contain an organic material.

A distance between a first end of the bank BNK and a first end of the first insulating layer INS1 positioned over the first electrode EL1 may correspond to a second distance dd2. For example, the second distance dd2 may correspond to about 1µm to about 2µm. Since the first insulating layer INS1 is positioned between the bank BNK and the first electrode EL1, a distance margin between the bank BNK and the first electrode EL1 may be secured.

Therefore, in the process of arranging the light emitting elements LD, even if at least one light emitting element LD is positioned at an angle with respect to a side surface of the bank BNK, the light emitting element LD electrically connecting the first electrode EL1 and the second electrode EL2 may be spaced apart from the first electrode EL1. Thus, in the case that the display device is electrically connected, the possibility of a short circuit may be reduced. Therefore, the display device can enhance the yield of the display panel and can enhance the luminance and efficiency of the display panel.

The light emitting element LD is located over the first electrode EL1. Specifically, the coupling electrode layer 140 of the light emitting element LD may be located over the first electrode EL1, and the first electrode EL1 and the coupling electrode layer 140 of the light emitting element LD may directly contact each other. Thus, the first driving voltage VDD of FIG. 5 applied to the first electrode EL1 may be transmitted to the light emitting element LD. As the first electrode EL1 directly contacts the coupling electrode layer 140 of the light emitting element LD, the driving voltage or current may be stably transmitted to the first semiconductor layer 110 (see FIG. 3) of the light emitting element LD. Further, the second semiconductor layer 130 (see FIG. 3) of the light emitting element LD may directly contact the second electrode EL2 which will be described below, so that the light emitting element LD may emit light.

The second insulating layer INS2 is located over the first electrode EL1 and the first insulating layer INS1 and is located to at least partially cover (or overlap) the first electrode EL1 and the first insulating layer INS1. Further, the second insulating layer INS2 may be located between the light emitting element LD and the bank BNK to support the light emitting element LD between two adjacent banks BNK. The second insulating layer INS2 may be positioned to cover at least a portion of the side surface of the bank BNK and at least a portion of the side surface of the light emitting element LD. The upper surface of the light emitting element LD may be exposed by the second insulating layer INS2.

The second insulating layer INS2 may be an organic layer including an organic material. The second insulating layer INS2 may include an inorganic material.

The second electrode EL2 is positioned over the second insulating layer INS2 and the light emitting element LD. The second electrode EL2 is positioned to cover the entire surface of the second insulating layer INS2 and also directly contacts and entirely overlaps in a cross-sectional view the light emitting element LD. The second electrode EL2 may be a cathode. The second electrode EL2 is positioned over the upper surface of the light emitting element LD, and the second electrode EL2 directly contacts the second semiconductor layer 130 (see FIG. 3) of the light emitting element LD. Thus, the second driving voltage VSS of FIG. 5 applied to the second electrode EL2 may be transmitted to the light emitting element LD.

FIG. 16 is a schematic sectional view illustrating a display device also disclosed herein and not forming part of the claimed invention. Since the configuration shown in FIG. 16 is similar to that of FIG. 15, differences will be described below.

Referring to FIG. 16, in the process of arranging the light emitting element LD, the light emitting element LD may be included in ink and sprayed onto the first electrode EL1 and the first insulating layer INS1. For example, the coupling electrode layer 140 of the light emitting element LD may be disposed at a predetermined angle with respect to the upper surface of the first insulating layer INS1 along the oblique side of the bank BNK.

Since the first electrode EL1 and the bank BNK are spaced apart from each other by the first insulating layer INS1, the light emitting element LD may be located not to contact the first electrode EL1 even if the light emitting element LD is inclined at a predetermined angle. The light emitting element LD may be located to contact only the second electrode EL2.

Therefore, even if the coupling electrode layer 140 of the light emitting element LD is obliquely disposed on the side surface of the bank BNK at a predetermined angle, the coupling electrode layer 140 contacts the first electrode EL1 or the second electrode EL2, so that it is possible to reduce the short-circuit of the pixel PXL including the light emitting element LD in the case that the display device is electrically connected. Therefore, the display device can enhance the yield of the display panel and can enhance the luminance and efficiency of the display panel.

While various embodiments have been described above, those skilled in the art will appreciate that various modifications, additions and substitutions are possible, without departing from the scope of the disclosure.

Therefore, the embodiments disclosed in this specification are only for illustrative purposes rather than limiting the disclosure. The scope of the claimed invention must be defined by the accompanying claims.

According to an embodiment, a bank and a first electrode are spaced apart from each other. Thus, even if a light emitting element is disposed obliquely on a side surface of the bank at a predetermined angle, the light emitting element contacts the first electrode or a second electrode, so that it is possible to reduce the occurrence of a short circuit in a pixel including the light emitting element, in the case that a display device is electrically connected.

Therefore, it is possible to enhance the yield of the display panel and to enhance the luminance and efficiency of the display panel.

The effects of the disclosure are not limited by the foregoing, and other various effects are anticipated herein.

## Claims

1. A display device comprising:
a base layer (BSL);
a pixel circuit layer (PCL) located over the base layer (BSL);
the pixel circuit layer (PCL) comprises:
a transistor (T1) located over the base layer (BSL), the transistor (T1) comprising:
an active layer (ACT);
a gate electrode (GAT);
a first electrode (TE1); and
a second electrode (TE2); and
a passivation layer (PSV) covering the transistor (T1);
a first electrode (EL1) located over the passivation layer (PSV) of the pixel circuit layer (PCL), the first electrode (EL1) is electrically connected to the second electrode (TE2) of the transistor (T1) through a contact hole (CH1) of the passivation layer (PSV);
a bank (BNK) located over the passivation layer (PSV) of the pixel circuit layer (PCL);
a light emitting element (LD) comprising a coupling electrode layer (140) located over the first electrode (EL1); an insulating layer (INS) disposed between the light emitting element (LD) and the bank (BNK) and exposing an upper surface of the light emitting element (LD); the insulating layer (INS) located over the passivation layer (PSV) and the first electrode (EL1); and the insulating layer (INS) overlaps at least a portion of the passivation layer (PSV) and the first electrode (EL1); and
a second electrode (EL2) located over the light emitting element (LD),
wherein the first electrode (EL1) and the bank (BNK) are spaced apart from each other and **characterized in that** the second electrode (EL2) entirely overlaps the insulating layer (INS) and also directly contacts and entirely overlaps in a cross-sectional view the upper surface of the light emitting element (LD).

2. The display device according to claim 1, wherein a distance between an end of the first electrode (EL1) and an end of the bank (BNK) is in a range of 1*µ*m to 2*µ*m.

3. The display device according to claim 1 or claim 2, wherein
the light emitting element (LD) comprises:
a first semiconductor layer (110);
an active layer (120) located on a first surface of the first semiconductor layer (110); and
a second semiconductor layer (130) located on a first surface of the active layer (120), and
the coupling electrode layer (140) is located on a second surface of the first semiconductor layer (110).

4. The display device according to claim 3, wherein:
(i) the coupling electrode layer (140) is electrically connected to the first electrode (EL1); and/or
(ii) the second semiconductor layer (130) is electrically connected to the second electrode (EL2).

5. The display device according to any one of claims 1 to 4, wherein a thickness (tt1) of the first electrode (EL1) is in a range of 1100Å to 1300Å.

6. A display device (DD) according to claim 1 comprising:
an emission area (EMA);
a non-emission area (NEA) enclosing the emission area (EMA);
the bank (BNK) is located in the non-emission area (NEA), and comprises an opening (OPN1) corresponding to the emission area (EMA);
the first electrode (EL1) is located in the opening (OPN1) of the bank (BNK);
the light emitting element (LD) is located in the emission area (EA); and
the second electrode (EL2) entirely overlaps the bank (BNK) and the first electrode (EL1).

7. The display device (DD) according to claim 6, wherein:
(i) a distance (dd1) between an outside of the first electrode (EL1) and an inside of the bank (BNK) is in a range of 1*µ*m to 2*µ*m; and/or
(ii) the first electrode (EL1) is an anode electrode,
the first electrode (EL1) is electrically connected to an electrode of a driving transistor (T1) through a contact hole (CH1), and
the contact hole (CH1) is located in the emission area (EMA).

8. The display device (DD) according to claim 6 or claim 7, wherein
the light emitting element (LD) comprises:
a first semiconductor layer (110);
an active layer (120) located on a first surface of the first semiconductor layer (110); and
a second semiconductor layer (130) located on a first surface of the active layer (120), and
the coupling electrode layer (140) is located on a second surface of the first semiconductor layer (110).

9. The display device (DD) according to claim 8, wherein:
(i) the coupling electrode layer (140) is electrically connected to the first electrode (EL1); and/or
(ii) the second semiconductor layer (130) is electrically connected to the second electrode (EL2).

## Patentansprüche

1. Anzeigevorrichtung, die Folgendes umfasst:
eine Basisschicht (BSL);
eine Pixelschaltungsschicht (PCL), die sich über der Basisschicht (BSL) befindet;
wobei die Pixelschaltungsschicht (PCL) Folgendes umfasst:
einen Transistor (T1), der sich über der Basisschicht (BSL) befindet, wobei der Transistor (T1) Folgendes umfasst:
eine aktive Schicht (ACT);
eine Gate-Elektrode (GAT);
eine erste Elektrode (TE1); und
eine zweite Elektrode (TE2); und
eine Passivierungsschicht (PSV), die den Transistor (T1) bedeckt;
eine erste Elektrode (EL1), die sich über der Passivierungsschicht (PSV) der Pixelschaltungsschicht (PCL) befindet, wobei die erste Elektrode (EL1) über ein Kontaktloch (CH1) der Passivierungsschicht (PSV) elektrisch mit der zweiten Elektrode (TE2) des Transistors (T1) verbunden ist;
einen Damm (BNK), der sich über der Passivierungsschicht (PSV) der Pixelschaltungsschicht (PCL) befindet;
ein lichtemittierendes Element (LD), umfassend eine Kopplungselektrodenschicht (140), die sich über der ersten Elektrode (EL1) befindet; eine Isolierschicht (INS), die zwischen dem lichtemittierenden Element (LD) und dem Damm (BNK) angeordnet ist und eine Oberseite des lichtemittierenden Elements (LD) freilegt; wobei sich die Isolierschicht (INS) über der Passivierungsschicht (PSV) und der ersten Elektrode (EL1) befindet; und die Isolierschicht (INS) mindestens einen Abschnitt der Passivierungsschicht (PSV) und der ersten Elektrode (EL1) überlappt; und
eine zweite Elektrode (EL2), die sich über dem lichtemittierenden Element (LD) befindet,
wobei die erste Elektrode (EL1) und der Damm (BNK) voneinander beabstandet sind, und **dadurch gekennzeichnet, dass**
die zweite Elektrode (EL2) die Isolierschicht (INS) vollständig überlappt und auch die Oberseite des lichtemittierenden Elements (LD) direkt berührt und in einer Querschnittsansicht vollständig überlappt.

2. Anzeigevorrichtung nach Anspruch 1, wobei ein Abstand zwischen einem Ende der ersten Elektrode (EL1) und einem Ende des Damms (BNK) in einem Bereich von 1 µm bis 2 µm liegt.

3. Anzeigevorrichtung nach Anspruch 1 oder Anspruch 2, wobei
das lichtemittierende Element (LD) Folgendes umfasst:
eine erste Halbleiterschicht (110);
eine aktive Schicht (120), die sich auf einer ersten Oberfläche der ersten Halbleiterschicht (110) befindet; und
eine zweite Halbleiterschicht (130), die sich auf einer ersten Oberfläche der aktiven Schicht (120) befindet, und
sich die Kopplungselektrodenschicht (140) auf einer zweiten Oberfläche der ersten Halbleiterschicht (110) befindet.

4. Anzeigevorrichtung nach Anspruch 3, wobei:
(i) die Kopplungselektrodenschicht (140) elektrisch mit der ersten Elektrode (EL1) verbunden ist; und/oder
(ii) die zweite Halbleiterschicht (130) elektrisch mit der zweiten Elektrode (EL2) verbunden ist.

5. Anzeigevorrichtung nach einem der Ansprüche 1 bis 4, wobei eine Dicke (tt1) der ersten Elektrode (EL1) in einem Bereich von 1 100 Å bis 1 300 Å liegt.

6. Anzeigevorrichtung (DD) nach Anspruch 1, die Folgendes umfasst:
einen Emissionsbereich (EMA);
einen Nichtemissionsbereich (NEA), der den Emissionsbereich (EMA) umschließt;
sich der Damm (BNK) im Nichtemissionsbereich (NEA) befindet und eine Öffnung (OPN1) entsprechend dem Emissionsbereich (EMA) umfasst;
sich die erste Elektrode (EL1) in der Öffnung (OPN1) des Damms (BNK) befindet;
sich das lichtemittierende Element (LD) im Emissionsbereich (EA) befindet; und
die zweite Elektrode (EL2) den Damm (BNK) und die erste Elektrode (EL1) vollständig überlappt.

7. Anzeigevorrichtung (DD) nach Anspruch 6, wobei:
(i) ein Abstand (dd1) zwischen einer Außenseite der ersten Elektrode (EL1) und einer Innenseite des Damms (BNK) in einem Bereich von 1 µm bis 2 µm liegt; und/oder
(ii) die erste Elektrode (EL1) eine Anodenelektrode ist,
die erste Elektrode (EL1) über ein Kontaktloch (CH1) elektrisch mit einer Elektrode eines Treibertransistors (T1) verbunden ist und
sich das Kontaktloch (CH1) im Emissionsbereich (EMA) befindet.

8. Anzeigevorrichtung (DD) nach Anspruch 6 oder Anspruch 7, wobei
das lichtemittierende Element (LD) Folgendes umfasst:
eine erste Halbleiterschicht (110);
eine aktive Schicht (120), die sich auf einer ersten Oberfläche der ersten Halbleiterschicht (110) befindet; und
eine zweite Halbleiterschicht (130), die sich auf einer ersten Oberfläche der aktiven Schicht (120) befindet, und
sich die Kopplungselektrodenschicht (140) auf einer zweiten Oberfläche der ersten Halbleiterschicht (110) befindet.

9. Anzeigevorrichtung (DD) nach Anspruch 8, wobei:
(i) die Kopplungselektrodenschicht (140) elektrisch mit der ersten Elektrode (EL1) verbunden ist; und/oder
(ii) die zweite Halbleiterschicht (130) elektrisch mit der zweiten Elektrode (EL2) verbunden ist.

## Revendications

1. Dispositif d'affichage comprenant :
une couche de base (BSL) ;
une couche de circuit de pixel (PCL) située sur la couche de base (BSL) ;
la couche de circuit de pixel (PCL) comprend :
un transistor (T1) situé sur la couche de base (BSL), le transistor (T1) comprenant :
une couche active (ACT) ;
une électrode de grille (GAT) ;
une première électrode (TE1) ; et
une seconde électrode (TE2) ; et
une couche de passivation (PSV) recouvrant le transistor (T1) ;
une première électrode (EL1) située sur la couche de passivation (PSV) de la couche de circuit de pixel (PCL), la première électrode (EL1) est électriquement connectée à la seconde électrode (TE2) du transistor (T1) à travers un trou de contact (CH1) de la couche de passivation (PSV) ;
un banc (BNK) situé sur la couche de passivation (PSV) de la couche de circuit de pixel (PCL) ;
un élément électroluminescent (LD) comprenant une couche d'électrode de couplage (140) située sur la première électrode (EL1) ; une couche d'isolation (INS) disposée entre l'élément électroluminescent (LD) et le banc (BNK) et exposant une surface supérieure de l'élément électroluminescent (LD) ; la couche d'isolation (INS) située sur la couche de passivation (PSV) et la première électrode (EL1) ; et la couche d'isolation (INS) chevauche au moins une portion de la couche de passivation (PSV) et de la première électrode (EL1) ; et
une seconde électrode (EL2) située sur l'élément électroluminescent (LD),
dans lequel la première électrode (EL1) et le banc (BNK) sont espacés l'un de l'autre et **caractérisé en ce que**
la seconde électrode (EL2) chevauche entièrement la couche d'isolation (INS) et entre également directement en contact et chevauche entièrement dans une vue transversale la surface supérieure de l'élément électroluminescent (LD).

2. Dispositif d'affichage selon la revendication 1, dans lequel une distance entre une extrémité de la première électrode (EL1) et une extrémité du banc (BNK) se situe dans une plage de 1 µm à 2 µm.

3. Dispositif d'affichage selon la revendication 1 ou la revendication 2, dans lequel
l'élément électroluminescent (LD) comprend :
une première couche semi-conductrice (110) ;
une couche active (120) située sur une première surface de la première couche semi-conductrice (110) ; et
une seconde couche semi-conductrice (130) située sur une première surface de la couche active (120), et
la couche d'électrode de couplage (140) est située sur une seconde surface de la première couche semi-conductrice (110).

4. Dispositif d'affichage selon la revendication 3, dans lequel :
(i) la couche d'électrode de couplage (140) est électriquement connectée à la première électrode (EL1) ; et/ou
(ii) la seconde couche semi-conductrice (130) est électriquement connectée à la seconde électrode (EL2).

5. Dispositif d'affichage selon l'une quelconque des revendications 1 à 4, dans lequel une épaisseur (tt1) de la première électrode (EL1) se situe dans une plage de 1 100 Å à 1 300 Å.

6. Dispositif d'affichage (DD) selon la revendication 1, comprenant :
une zone d'émission (EMA) ;
une zone de non-émission (NEA) entourant la zone d'émission (EMA) ;
le banc (BNK) est situé dans la zone de non-émission (NEA), et comprend une ouverture (OPN1) correspondant à la zone d'émission (EMA) ;
la première électrode (EL1) est située dans l'ouverture (OPN1) du banc (BNK) ;
l'élément électroluminescent (LD) est situé dans la zone d'émission (EA) ; et
la seconde électrode (EL2) chevauche entièrement le banc (BNK) et la première électrode (EL1).

7. Dispositif d'affichage (DD) selon la revendication 6, dans lequel :
(i) une distance (dd1) entre un extérieur de la première électrode (EL1) et un intérieur du banc (BNK) se situe dans une plage de 1 µm à 2 µm ; et/ou
(ii) la première électrode (EL1) est une électrode d'anode,
la première électrode (EL1) est électriquement connectée à une électrode d'un transistor de pilotage (T1) à travers un trou de contact (CH1), et
le trou de contact (CH1) est situé dans la zone d'émission (EMA).

8. Dispositif d'affichage (DD) selon la revendication 6 ou la revendication 7, dans lequel
l'élément électroluminescent (LD) comprend :
une première couche semi-conductrice (110) ;
une couche active (120) située sur une première surface de la première couche semi-conductrice (110) ; et
une seconde couche semi-conductrice (130) située sur une première surface de la couche active (120), et
la couche d'électrode de couplage (140) est située sur une seconde surface de la première couche semi-conductrice (110).

9. Dispositif d'affichage (DD) selon la revendication 8, dans lequel :
(i) la couche d'électrode de couplage (140) est électriquement connectée à la première électrode (EL1) ; et/ou
(ii) la seconde couche semi-conductrice (130) est électriquement connectée à la seconde électrode (EL2).
